Europäisches Patentamt

European Patent Office

Office européen des brevets

(11) Numéro de publication : **0 149 394**
**B1**

(19)

(12) **FASCICULE DE BREVET EUROPÉEN**

(45) Date de publication du fascicule du brevet :
27.07.88

(21) Numéro de dépôt : **84402707.8**

(22) Date de dépôt : **21.12.84**

(51) Int. Cl.⁴ : **B 32 B 15/02**, B 32 B 15/20,
H 01 Q   9/04, H 01 P   3/08,
H 05 K   3/46

(54) Procédé de réalisation d'un support à base de polypropylène comportant plusieurs couches métalliques et support obtenu par ce procédé.

(30) Priorité : 29.12.83 FR 8321017

(43) Date de publication de la demande :
24.07.85 Bulletin 85/30

(45) Mention de la délivrance du brevet :
27.07.88 Bulletin 88/30

(84) Etats contractants désignés :
BE DE FR GB IT

(56) Documents cités :
FR-A- 1 418 731
FR-A- 1 504 920
FR-A- 2 072 162
US-A- 3 240 662
US-A- 3 244 795
US-A- 3 335 050
US-A- 3 505 159
US-A- 3 532 570
US-A- 3 557 983

(73) Titulaire : **Demeure, Loic**
**Route de Pleumeur**
**F-22700 Perros Guirec (FR)**

**Garnier, Yvonne**
**Rue de Dixmude**
**F-22300 Lannion (FR)**

**Le Rouzic, Jean**
**Convenant An Dour Saint Quay Perros**
**F-22700 Perros Guirec (FR)**

(72) Inventeur : **Demeure, Loic**
**Route de Pleumeur**
**F-22700 Perros Guirec (FR)**
Inventeur : **Garnier, Yvonne**
**Rue de Dixmude**
**F-22300 Lannion (FR)**
Inventeur : **Le Rouzic, Jean**
**Convenant An Dour Saint Quay Perros**
**F-22700 Perros Guirec (FR)**

(74) Mandataire : **Mongrédien, André et al**
**c/o BREVATOME 25, rue de Ponthieu**
**F-75008 Paris (FR)**

EP 0 149 394 B1

Jouve, 18, rue St-Denis, 75001 Paris, France

## Description

La présente invention a pour objet un procédé de réalisation d'un support métallisé à base de polypropylène utilisable en particulier dans les circuits électroniques et dans le domaine des communications pour la réalisation d'éléments rayonnants tels que les antennes « microstrips » (microbandes), ainsi que le support ainsi obtenu.

L'invention a pour but d'obtenir un support métallisé pouvant être utilisé dans toute application nécessitant un support à faible constante diélectrique, à faible perte et à caractéristiques diélectriques stables en fonction de la température et de la fréquence.

Elle vise enfin un coût modique de réalisation rendu possible du fait d'une part de la disponibilité en grande quantité et pour un modeste prix du polypropylène, d'autre part de l'utilisation d'équipements employés déjà dans les circuits imprimés.

Parmi les stratifiés susceptibles d'être utilisés pour la fabrication d'éléments rayonnants, on peut trouver divers matériaux métallisés tels que les polyimides, les époxydes, les polyesters, les polysulfones, le polystyrène, le polyéthylène ou le polytétrafluoréthylène, ces matériaux pouvant être commercialisés sous différentes appellations commerciales.

Ces matériaux ayant des caractéristiques électriques soit voisines soit différentes de celles proposées selon l'invention présentent cependant divers inconvénients résultant pour une part du prix des matières premières mises en œuvre, pour une autre part des difficultés de métallisation ; en effet, l'adhérence entre le polymère et le métal est parfois réalisée par l'intermédiaire d'un adhésif.

Par ailleurs, les supports métallisés cités ci-dessus sont principalement utilisés pour des applications « hyperfréquences » relatives à des domaines particuliers tels que le spatial ou le militaire où les problèmes de coûts ne constituent pas le critère sélectif de filière technologique. Mais, dans la mesure où le besoin de ce type de support est destiné à s'accroître, notamment dans les domaines de grande diffusion comme la réception d'images transmises par satellites, les problèmes de coûts deviennent primordiaux.

La présente invention a précisément pour objet un procédé de réalisation d'un support métallisé qui permet de s'affranchir des inconvénients de l'art antérieur précité, en procurant notamment un support isolant disponible en grand format pour un faible coût, de mise en œuvre aisée, possédant des caractéristiques électriques intéressantes, notamment une constante diélectrique $\varepsilon$ et un angle de perte tg$\delta$ faibles ($\varepsilon < 2$ ; tg$\delta \sim 3 \cdot 10^{-4}$), supportant une métallisation au moins égale à 10μm dans le cas du cuivre, utilisable dans la gamme de fréquences comprises entre 15 et 60 GHz, et préférentiellement dans la bande 15-35 GHz.

Selon le procédé objet de l'invention, celui-ci comprend les étapes suivantes :

on réalise un premier support en pressant à chaud, sur une couche de polypropylène, au moins un feuillard métallique la pression de collage étant inférieure à 10 kg/cm² et la température de travail montant progressivement, au cours de cette étape, à une valeur comprise entre 165 et 180 °C, et

on reporte le support ainsi obtenu sur une deuxième feuille métallique par l'intermédiaire d'une couche de liaison en un copolymère du polypropylène, la face du premier support comportant ledit feuillard métallique étant en contact avec ladite couche de liaison.

Selon un mode préféré de réalisation, la deuxième feuille métallique fait elle-même partie d'un autre support à base de polypropylène. Quant au matériau constituant la couche de liaison, ce peut être du polypropylène additionné de polyéthylène.

La réalisation du premier support peut se faire soit dans une presse chauffante, soit par laminage à chaud.

Selon un autre aspect de l'invention, on soumet le feuillard à un traitement de surface sur au moins une de ses faces avant de le coller sur le support en polypropylène ce traitement pouvant être un traitement d'oxydation. Dans le cas du cuivre, on peut, après collage, faire subir à sa face externe un traitement de désoxydation. Dans le cas de l'aluminium, le traitement initial peut être une oxydation anodique non colmatée.

D'autres caractéristiques de l'invention ressortiront de la description qui va suivre, donnée à titre purement illustratif et nullement limitatif, en regard des dessins annexés dans lesquels :

la figure 1 est une vue en coupe et en perspective d'un premier support constitué d'un support en polypropylène recouvert au moins partiellement sur chacune de ses faces par une feuille métallique, les feuilles métalliques étant de même nature,

la figure 2 est une vue en coupe et en perspective d'un premier support qui dans cet exemple, est recouvert sur chacune de ses faces par au moins une feuille métallique, les feuilles correspondant aux deux faces étant de nature différente,

la figure 3 est une vue en coupe et en perspective du support diélectrique représenté figure 1, lui-même rapporté sur un support en aluminium ou en alliage d'aluminium,

la figure 4 est une vue en coupe et en perspective du support diélectrique représenté figure 1, lui-même reporté après gravure sur un copolymère du polypropylène, celui-ci pouvant être métallisé ou non, et

la figure 5 est une vue en coupe et en perspective de plusieurs supports diélectriques du type représenté figure 1, eux-mêmes réunis après gravure par l'intermédiaire de couches de copolymère du polypropylène.

Dans la description qui suit, les éléments constitutifs du support métallisé sont explicités dans l'ordre de leur montage en suivant les différentes phases successives du procédé de fabrication envisagé.

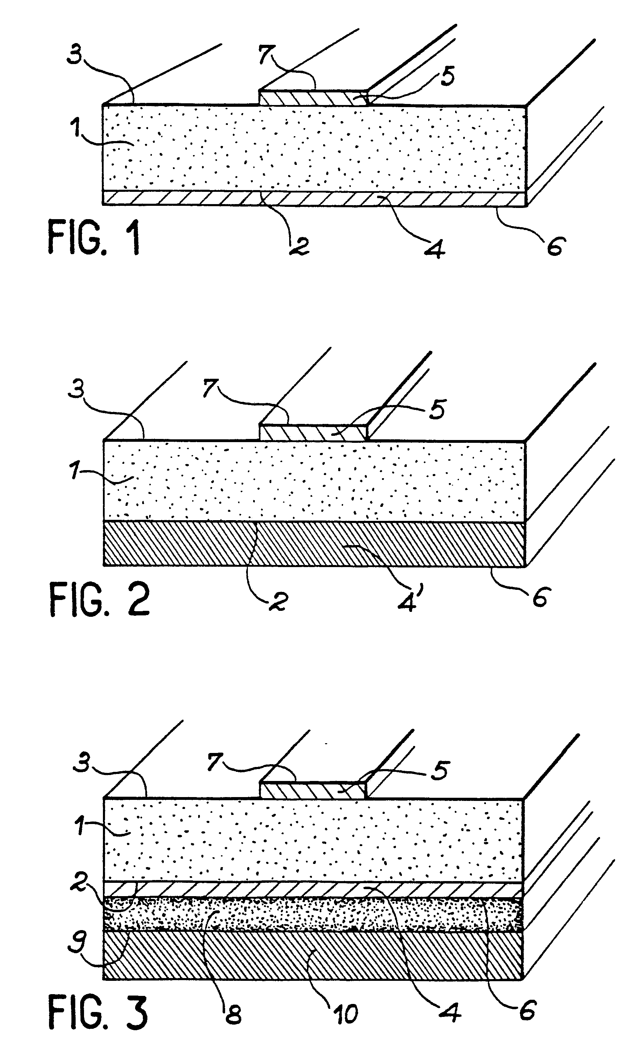

La figure 1 illustre un premier support qui, dans le cas particulier décrit ici, est constitué d'une couche de polypropylène 1 dont la surface inférieure 2 et la surface supérieure 3 sont respectivement recouvertes au moins partiellement d'un feuillard de cuivre inférieur et d'un feuillard de cuivre supérieur 5.

La figure 2 représente un premier support semblable à celui de la figure 1, mais dans lequel le feuillard de cuivre 4 a été remplacé par une feuille d'aluminium ou d'alliage d'aluminium 4'.

La figure 3 illustre un support multicouches selon l'invention obtenu en collant le support de la figure 1 sur une plaque d'aluminium ou d'alliage d'aluminium 10 par l'intermédiaire d'une couche de polymère adhésif 8.

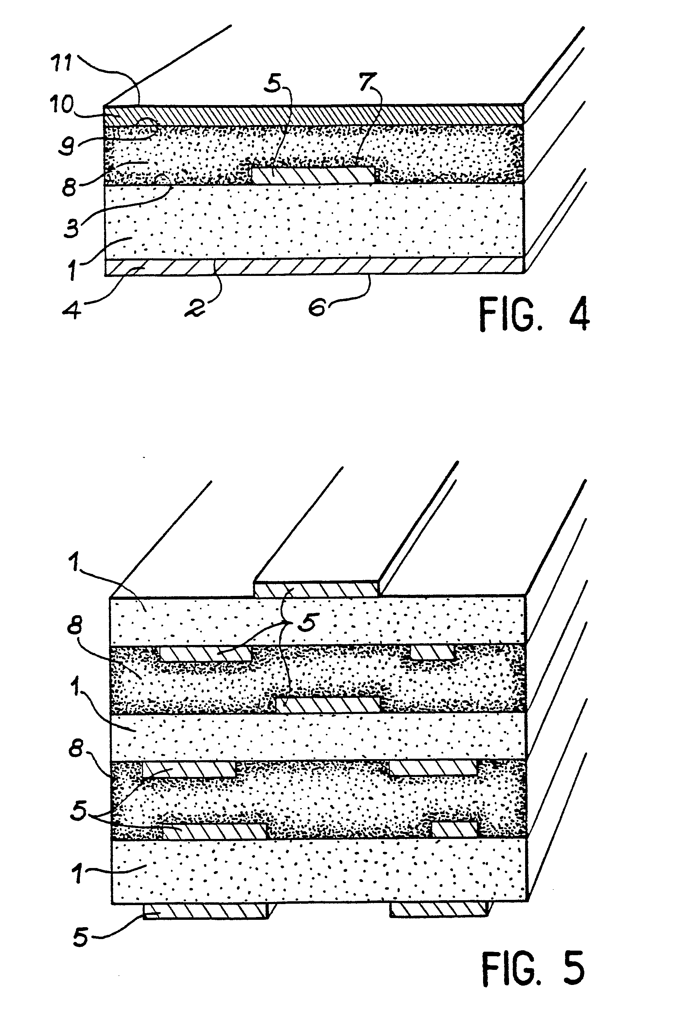

Les figures 4 et 5 montrent comment on peut réaliser un support multicouches en réunissant différents supports métallisés, préalablement gravés, par l'intermédiaire d'un copolymère du polypropylène se présentant sous la forme d'une couche de liaison 8.

Pour réaliser le premier support illustré à la figure 1, le polypropylène non chargé, en feuille 1 d'épaisseur au moins égale à l'épaisseur du diélectrique souhaité, est découpé soigneusement à un format dont le volume correspond à celui de la cavité de l'outillage de pressage. Cette opération devant être effectuée avec soin, on utilise par exemple des gants pour les manipulations. Le polypropylène est ensuite recouvert sur chacune de ses deux faces 2 et 3 par deux feuillards en cuivre électrolytique 4 et 5 d'un ou de quelques dizaines de μm d'épaisseur dont la surface mise au contact du polypropylène a été modifiée par oxydation du métal permettant ainsi la création d'une liaison physique et moléculaire avec le polypropylène.

L'oxydation du métal a été obtenue par exemple par immersion après dégraissage pendant 15 minutes dans une solution aqueuse à 95 °C comportant 30 g/litre de chlorite de soude $NaClO_2$, 10 g/litre de phosphate trisodique, $Na_3PO_4$, $12H_2O$, et 25 g/litre de soude NaOH.

Bien entendu, à cet effet, d'autres traitements peuvent être envisagés. L'ensemble déposé à l'intérieur de la presse chauffante est soumis à un cycle température-pression. Dans le cas particulier de la réalisation faite, le cycle utilisé est défini par les étapes suivantes :

1 : pression de touche 0,6 $kg/cm^2$ ;

2 : montée en température à raison de 8 °C par minute jusqu'à 180 °C ;

3 : pression de collage 6 $kg/cm^2$ pendant 2 minutes ;

4 : refroidissement pendant un quart d'heure avec maintien de la pression ;

5 : diminution progressive de la pression ;

6 : ouverture de la presse et démoulage du support métallisé obtenu.

Une dernière opération consiste à réaliser une découpe des bords extérieurs du support métallisé.

Enfin, dans le cas où le traitement préalable du cuivre a été effectué sur ses deux faces, notamment les faces 6 et 7, il est nécessaire de désoxyder le cuivre en surface par exemple en l'immergeant dans une solution d'acide chlorhydrique dilué.

Quel que soit le traitement chimique subi par le métal, le support métallisé à base de polypropylène obtenu présente de nombreux avantages, notamment au vu de ses caractéristiques principales : il présente l'avantage d'une bonne adhérence du métal sur le propylène ; dans le cas du cuivre, son adhérence est égale à plusieurs dizaines de $kg/cm^2$, et on obtient de faibles constantes diélectriques $\varepsilon$ et de faibles pertes (tg $\delta$) dans la gamme de fréquences de 5 à 15 GHz ($\varepsilon = 1,90$ (à 5 GHz), 1,92 (à 10 GHz), 1,93 (à 15 GHz)) (tg $\delta = 1$ dB/m (à 5 GHz), 1,8 dB/m (à 10 GHz), 2 dB/m (à 15 GHz)).

Un autre avantage d'un tel support métallisé à base de polypropylène réside en sa résistance aux différents essais climatiques, conformément aux normes en vigueur, tels que l'essai de chaleur humide et l'essai de rayonnement appliqué aux câbles et dispositifs polymères utilisés à l'extérieur.

Enfin, un dernier avantage de ce support métallisé à base de polypropylène est dû à son aptitude à subir les différentes étapes de réalisation des circuits imprimés, ne nécessitant pas de températures supérieures à 150 °C : température de ramollissement sous charge du polypropylène.

Dans le cas de la figure 2, il s'agit d'améliorer les caractéristiques mécaniques d'un premier support obtenu comme indiqué ci-dessus et notamment d'améliorer la rigidité et la planéité du support sans accroître exagérément son poids. On procède au collage sur la face 3 du polypropylène d'une feuille de cuivre oxydé de la façon décrite précédemment et, sur la face 2, au collage d'une plaque d'aluminium ou d'alliage d'aluminium oxydée anodiquement et non colmatée. Ces deux opérations de collage peuvent s'effectuer simultanément ou successivement.

Pour réaliser le support de la figure 3, on part d'un premier support tel qu'illustré à la figure 1 (cuivre, polypropylène, cuivre) en ayant soin d'avoir conservé ou de réaliser l'oxydation du cuivre sur la face 6. Cet ensemble est collé sur une plaque 10 d'aluminium ou d'alliage d'aluminium ayant reçu sur la face 9 une oxydation anodique, le collage étant effectué par l'intermédiaire d'un film de polypropylène 8.

Dans le cas de la figure 4, il s'agit de réaliser un circuit multicouches avec gravure d'une ou plusieurs couches conductrices internes. Le procédé consiste à partir d'un premier support semblable à celui de la figure 1 (cuivre-polypropylène-cuivre), à graver la couche 5 et, en ayant soin d'avoir conservé ou d'avoir réalisé l'oxydation du cuivre sur la face 7, à coller celle-ci sur une couche 8 d'un copolymère du polypropylène. Ce copolymère est obtenu par addition au polypropylène d'une charge de polyéthylène, charge permettant d'abaisser suffisamment la température de collage de la couche 8 sur la face gravée du support précédemment réalisé pour ne pas provoquer de détérioration de la couche 5 au cours de cette opération.

Un feuillard ou une plaque métallique 10 peut après préparation de la face 9, être, dans un même cycle ou ensuite, collé sur le copolymère. La même opération peut ensuite ou simultanément être réalisée en partant de la face 6.

Pour réaliser un circuit ayant plus de quatre couches métalliques, figure 5, le procédé consiste à relier par l'intermédiaire du copolymère 8 les différents circuits préalablement réalisés à partir de premiers supports semblables à celui de la figure 1.

Quelle que soit la variante de réalisation adoptée pour la fabrication du support métallisé à base de polypropylène selon l'invention, on constate avantageusement d'une part la simplicité des moyens permettant son obtention, d'autre part l'utilisation d'aucun équipement supplémentaire pour les industriels pratiquant la stratification ; en effet, le matériel se résume à une simple presse chauffante permettant d'atteindre des températures situées entre 165 et 180 °C. Fort de ce qui précède, on aboutit à la mise en forme aisée et peu chère du support métallisé.

Bien entendu et comme il résulte déjà de ce qui précède, il va de soi que l'invention ne se limite nullement aux exemples de réalisation plus spécialement décrits. En particulier, on pourrait améliorer les qualités mécaniques et électriques par l'addition de différentes charges au propylène.

Par ailleurs, la protection de l'antenne constituée par le support métallisé de l'invention vis-à-vis de l'environnement peut s'effectuer aisément par pressage sur ce support d'un film de polypropylène ou de tout autre film thermoplastique compatible avec les applications envisagées.

## Revendications

1. Procédé de réalisation d'un support comportant plusieurs couches métalliques (5, 10), caractérisé en ce qu'il comporte les étapes suivantes consistant à :

a) réaliser un premier support en collant à chaud, sur une couche de polypropylène (1), au moins un feuillard métallique (5), la pression de collage étant inférieure à 10 kg/cm² et la température de travail montant progressivement, au cours de cette étape, à une valeur comprise entre 165 et 180 °C, et

b) coller le support ainsi obtenu sur une deuxième feuille métallique (10) par l'intermédiaire d'une couche de liaison (8) en un copolymère du polypropylène, la face du premier support (8) comportant ledit feuillard métallique (5) étant en contact avec ladite couche de liaison (8).

2. Procédé selon la revendication 1, caractérisé en ce que la deuxième feuille métallique (10) fait partie d'un autre premier support comprenant une couche de polypropylène.

3. Procédé selon la revendication 2, caractérisé en ce qu'on réunit les uns aux autres plusieurs premiers supports comprenant chacun une couche de polypropylène (1) dont chaque face comporte au moins un feuillard métallique (5), à l'aide de couches de liaison (8) en un copolymère de polypropylène et de polyéthylène, chaque couche de liaison (8) étant placée entre deux premiers supports consécutifs.

4. Procédé selon l'une quelconque des revendications 1 à 3, caractérisé en ce qu'on réalise le premier support par pressage à chaud dans une presse chauffante.

5. Procédé selon l'une quelconque des revendications 1 à 3, caractérisé en ce qu'on réalise le premier support par laminage à chaud.

6. Procédé selon l'une quelconque des revendications 1 à 7, caractérisé en ce qu'on soumet ledit feuillard métallique (5) à un traitement de surface sur au moins une de ses faces avant de le coller sur le support (1) en polypropylène.

7. Procédé selon la revendication 6, caractérisé en ce que ledit traitement de surface est un traitement d'oxydation.

8. Procédé selon la revendication 7, caractérisé en ce que, ledit feuillard métallique (5) étant en cuivre, on le soumet à un traitement chimique d'oxydation et après collage sur le support en polypropylène (1), on fait subir à sa face externe (7) un traitement de désoxydation.

9. Procédé selon la revendication 7, caractérisé en ce que, ledit feuillard métallique (5) étant en aluminium ou alliage d'aluminium, on lui fait subir un traitement de surface sous forme d'oxydation anodique non colmatée.

## Claims

1. Process for producing a support having several metal layers (5, 10), characterized in that it comprises the following stages :

a) producing a first support by hot bonding to a polypropylene layer (1) at least one metal band (5), the bonding pressure being below 10 kg/cm² and the working temperature rising progressively during second stage to a value between 165 and 180 °C and

b) bonding the thus obtained support to a second metal sheet (10) by a polypropylene copolymer bonding layer (10), the face of the first support (8) having said metal band (5) being in contact with said bonding layer (8).

2. Process according to claim 1, characterized in that the second metal sheet (10) forms part of first support having a polypropylene layer.

3. Process according to claim 2, characterized in that several first supports, each having a polypropylene layer (1), are joined together and each face has at least one metal layer (5) using polypropylene and polyethylene copolymer bonding layers (8), each bonding layer (8) being placed between two consecutive first supports.

4. Process according to any one of the claims 1 to 3, characterized in that the first support is obtained by hot pressing in a heating press.

5. Process according to any one of the claims 1 to 3, characterized in that the first support is produced by hot lamination.

6. A process according to any one of the claims 1 to 5, characterized in that the metal band (5) undergoes a surface treatment on at least one of its faces before bonding it to the polypropylene support (1).

7. Process according to claim 6, characterized in that the surface treatment is an oxidation treatment.

8. Process according to claim 7, characterized in that as the metal band (5) is of copper, it undergoes a chemical oxidation treatment and after bonding to the polypropylene support (1), its outer face (7) undergoes a deoxidation treatment.

9. Process according to claim 7, characterized in that as the metal band (5) is of aluminium or aluminium alloy, it undergoes a surface treatment in the form of unsealed anodic oxidation.

## Patentansprüche

1. Verfahren zur Herstellung eines mehrere metallische Schichten (5, 10) umfassenden Trägers, dadurch gekennzeichnet, daß es die folgenden Schritte umfaßt, die darin bestehen :

a) einen ersten Träger herzustellen, indem bei Wärme auf eine Polypropylenschicht (1) wenigstens ein metallisches Bandmaterial (5) geklebt wird, wobei der Klebedruck niedriger als 10 kg/cm² ist und die Arbeitstemperatur fortschreitend während dieses Schrittes auf einen zwischen 165 und 180 °C liegenden Wert ansteigt, und

b) den derart erhaltenen Träger mittels einer Verbindungsschicht (8) aus einem Polypropylencopolymer auf ein zweites, metallisches Bandmaterial (10) zu kleben, wobei die das genannte metallische Bandmaterial (5) aufweisende Seite des ersten Trägers mit der genannten Verbindungsschicht (8) in Berührung steht.

2. Verfahren nach Anspruch 1, dadurch gekennzeichnet, daß das zweite, metallische Bandmaterial (10) Teil eines anderen ersten Trägers ist, der eine Polypropylenschicht aufweist.

3. Verfahren nach Anspruch 2, dadurch gekennzeichnet, daß man die einen mit den mehreren anderen ersten Trägern, die jeweils eine Propylenschicht (1) aufweisen, von der jede Seite wenigstens ein metallisches Bandmaterial (5) aufweist, mit Hilfe von Verbindungsschichten (8) aus einem Polypropylen-Polyethylen-Copolymer vereinigt, wobei jede Verbindungsschicht (8) zwischen zwei aufeinanderfolgenden, ersten Trägern angeordnet ist.

4. Verfahren nach irgendeinem der Ansprüche 1 bis 3, dadurch gekennzeichnet, daß man den ersten Träger durch Heißpressen in einer heizbaren Presse herstellt.

5. Verfahren nach irgendeinem der Ansprüche 1 bis 3, dadurch gekennzeichnet, daß man den ersten Träger durch Heißwalzen herstellt.

6. Verfahren nach irgendeinem der Ansprüche 1 bis 7, dadurch gekennzeichnet, daß man das genannte metallische Bandmaterial (5) einer Oberflächenbehandlung auf wenigstens einer seiner Seiten vor dem Aufkleben auf den Träger (1) aus Polypropylen aussetzt.

7. Verfahren nach Anspruch 6, dadurch gekennzeichnet, daß die genannte Oberflächenbehandlung eine Oxidationsbehandlung ist.

8. Verfahren nach Anspruch 7, dadurch gekennzeichnet, daß das genannte metallische Bandmaterial (5) aus Kupfer ist und man dieses einer chemischen Oxidationsbehandlung aussetzt und nach dem Kleben auf den Träger aus Polypropylen (1) an seine Außenseite (7) eine Desoxydierungsbehandlung vornimmt.

9. Verfahren nach Anspruch 7, dadurch gekennzeichnet, daß das genannte metallische Bandmaterial (5) aus Aluminium oder Aluminiumlegierung besteht und man dieses einer Oberflächenbehandlung in der Form einer anodischen Oxidation aussetzt.

FIG. 1

FIG. 2

FIG. 3

FIG. 4

FIG. 5